# EUROPEAN PATENT SPECIFICATION

(11) **EP 3 449 706 B1**
(45) Date of publication and mention of the grant of the patent: **17.02.2021**
(21) Application number: 16900320.9
(22) Date of filing: 28.04.2016
(51) Int. Cl.: H05K 5/03, H05K 5/04, H05K 9/00, H04H 20/78, H04N 7/10

(54) **STRUCTURAL ARRANGEMENT FOR A CATV FIELD DEVICE**
STRUKTURANORDNUNG FÜR EINE CATV-FELD-VORRICHTUNG
AGENCEMENT STRUCTURAL DESTINÉ À UN DISPOSITIF DE CHAMP DE TÉLÉVISION PAR CÂBLE

(43) Date of publication of application: 06.03.2019
(73) Proprietor: Teleste Oyj, 20660 Littoinen (FI)
(72) Inventor: RUMPUNEN, Toni, 21280 Raisio (FI); MATTILA, Markus, 24240 Salo (FI); FAHLBOM, Jarno, 20810 Turku (FI); RAINESTO, Mitja, 21110 Naantali (FI)
(74) Representative: Berggren Oy, Tampere
(86) International application number: PCT/FI2016/050273
(87) International publication number: WO 2017/187004

(56) References cited:
- WO-A1-01/99483
- WO-A1-2014/036096
- WO-A2-2012/122230
- US-A1- 2002 186 550
- US-A1- 2005 227 744
- US-A1- 2006 041 919
- US-A1- 2012 320 558
- US-A1- 2016 037 654

## Description

### Field of the invention

The present invention relates to CATV networks, and more particularly to a structure of a CATV field device.

### Background of the invention

Cable television (CATV) networks may be implemented with various techniques and network topologies, but currently most cable television networks are implemented as so-called HFC networks (Hybrid Fiber Coax), i.e. as combinations of a fibre network and a coaxial cable network. The distribution network for distributing the services from the main amplifier (a so-called headend) to the customers comprises a plurality of so-called field devices, such as fibre nodes, broadband amplifiers, etc.

The HFC field devices are typically implemented in a casted aluminium housing so as to provide a robust and secure, yet a lightweight structure. Casted aluminium HFC field devices usually have a plurality of shielding covers to protect the printed circuit board (PCB) and the components. Several materials are used for this purpose: paper, plastic, metal. Metallic shielding covers are typically secured to a right place and on a right height from the PCB by using mounting towers protruding from the PCB, to which towers the shielding covers are attached. The PCBs are attached to mechanics (i.e. the casted housing) with screws to make a good and reliable contact.

In many occasions, metallic shielding covers are mandatory due to their electromagnetic compatibility (EMC) properties, since the HFC devices have conducting surface above and below the PCB. Some components and power sources must typically be isolated for EMC reasons by additional sheet metal walls and shielding boxes. The high-voltage power sources must also be covered by shielding covers due to safety reasons.

Typically at least some of the components or functionalities in HFC field devices are implemented as plug-in components, or more generally as plug-in modules, so as to enable easy replacement of a broken or an outdated module. Also when configuring the network, the plug-in modules may be switched several times when aiming to optimize the operation of the field device in terms of the whole network configuration. The plug-in modules usually need a plastic or metallic guide to secure correct installation. The guide may be attached to the shielding cover or it may be a separate part.

However, the separate parts mentioned above, such as screws, shielding covers, mounting towers, shielding boxes and partition walls, typically need to be assembled manually on the PCB or in the housing. This causes additional manual work and delays in the manufacturing and the assembly time of a single apparatus becomes unnecessarily long. Moreover, most of the above-mentioned parts are installed on the PCB, thereby requiring space for installation, which in turn limits the number of components installable on the PCB.

Yet a further problem may occur in a situation, where the apparatus is operated in the CATV network and there is another RF device, such as cellular network base station, operating in the vicinity of apparatus. The cover or the cap of the apparatus typically provides sufficient protection against RF interference from other RF devices and disturbances from other sources. However, no maintenance or testing of the apparatus can be made without removing or opening the cover, which in turn would cause RF interference to the apparatus. As a result, the apparatus does not work properly, and it might even damage. Therefore, no reliable testing results can be achieved, and for the maintenance work, the apparatus practically needs to be shut down, thereby causing a breakdown in the service.

US 2005/227744 discloses a radio frequency (RF) tuner includes a tuner housing, a cover coupled to a first side of the housing, and a tuner printed circuit board (PCB) including a plurality of layers coupled to a second side of the housing, wherein the layers are configured to shield the tuner PCB thereby reducing electromagnetic interference emissions and RF radiated fields in said PCB.

WO 2012/122230 discloses a set top box comprising a bottom frame; a top cover; a printed circuit board positioned between the bottom frame and the top cover; and a top heat sink that completely covers or substantially covers the printed circuit board. The top heat sink comprises an access aperture for providing access to a reset point on the printed circuit board.

### Summary of the invention

Now there has been invented an improved apparatus, by which many of the above problems can be removed or at least alleviated. Herein below a field device of a CATV network is introduced, which is characterized by what is stated in the independent claim. Various embodiments of the invention are disclosed in the dependent claims. The scope of protection sought for various embodiments of the invention is set out by the independent claims. The embodiments and features, if any, described in this specification that do not fall under the scope of the independent claims are to be interpreted as examples useful for understanding various embodiments of the invention.

According to an aspect, there is provided an apparatus for use in cable television (CATV) network, the apparatus comprising: a housing; a printed circuit board (PCB) comprising components necessary for operating the apparatus, wherein the PCB is arranged within the housing; a detachable cover for the housing; and a casted covering plate made of electrically conducting material, wherein the covering plate is arranged, upon installation between the PCB and the detachable cover, to cover at least the PCB and attach the PCB to the housing, wherein the covering plate comprises at least one aperture for a test point of the apparatus or arranged as a guide for a plug-in module; and a test point connector is arranged in a first surface of the covering plate facing the detachable cover, and a conductor connected to the test point connector and protruding from the second opposite surface of the covering plate, wherein the conductor, upon said installation of the covering plate, is arranged to be pressed against an output of a test signal on the PCB.

According to an embodiment, a second surface of the covering plate facing the PCB is casted in a form that provides isolation walls and/or a shielding box around at least one component or a component group on the PCB.

According to an embodiment, the electrically conducting material is aluminium, zinc or an electrically conducting plastic.

According to an embodiment, the covering plate is attached to the housing by one screw.

These and other aspects of the invention and the embodiments related thereto will become apparent in view of the detailed disclosure of the embodiments further below.

### List of drawings

In the following, various embodiments of the invention will be described in more detail with reference to the appended drawings, in which
- Fig. 1: shows an example of the structure of an apparatus according to an embodiment of the invention with several parts separated from each other;
- Fig. 2: shows an example of the surface structure of a covering plate according to an embodiment of the invention;
- Fig. 3: shows an example of the structure of an apparatus according to an embodiment of the invention with the parts installed together; and
- Figs 4a, 4b: show an example of test point arrangement according to an embodiment of the invention.

### Description of embodiments

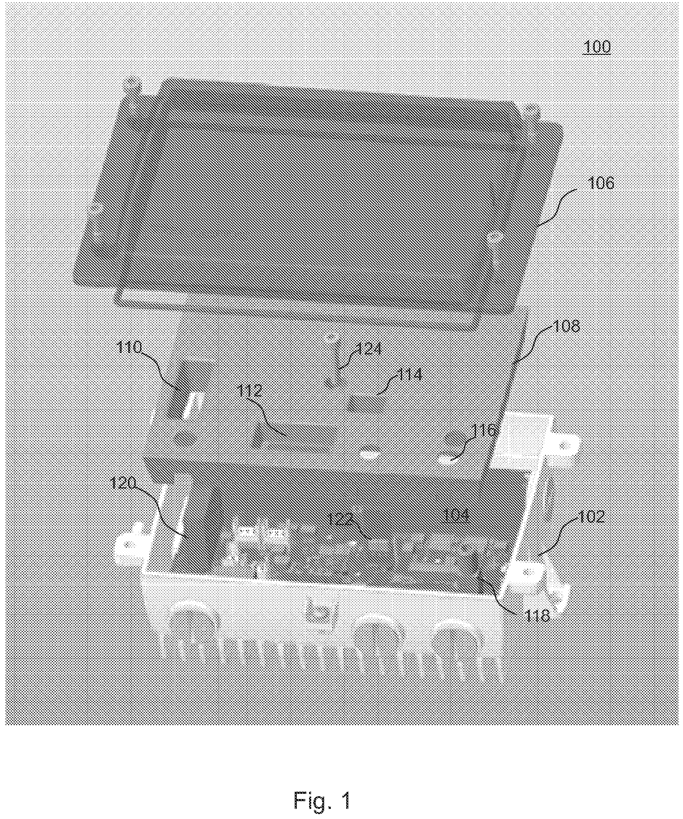

Figure 1 illustrates an example of the structure of an apparatus for use in cable television (CATV) network according to an embodiment. The apparatus 100 comprises a housing 102, a printed circuit board (PCB) 104 comprising components necessary for operating the apparatus, wherein the PCB is arranged within the housing 102 and a detachable cover 106 for the housing. The apparatus further comprises a casted covering plate 108 made of electrically conducting material, wherein the covering plate 108 is arranged, upon installation between the PCB 104 and the detachable cover 106, to cover at least the PCB and attach the PCB to the housing.

Thus, instead of using a plurality of shielding covers to protect the PCB and the components, the protection functionalities, both electrical and mechanical, can be achieved by a single casted covering plate. Regarding possible RF interference from other RF devices in the vicinity, the casted covering plate alone would provide an improved RF protection, even without the detachable cover. Moreover, instead of fastening the PCB to the housing using typically at least ten manually fastened screws, the PCB can be attached firmly to the housing by an appropriately designed casted covering plate. Since no screw holes are needed in the PCB, there is more space on the PCB for further components.

If the covering plate alone provides a sufficient RF protection, the covering plate could be even used as the outer cover of the apparatus instead of the detachable cover. At least the detachable cover could be made of plastic, for example, instead of aluminium, thereby proving savings in material and manufacturing costs.

According to an embodiment, the covering plate comprises at least one aperture 110, 112, 114, 116 for a test point 118 of the apparatus or arranged as a guide for a plug-in module 120, 122. Hence, no separate guides are needed for plug-ins, but the apertures in the covering plate can be designed such that they operate as guides.

This provides the further advantage that the detachable cover can be removed for maintenance or testing purposes without the fear that another RF device, such as cellular network base station, operating in the vicinity of apparatus would cause RF interference to the apparatus. Thus, an old, broken or non-optimal plug-in module can be replaced by a new plug-in module, or a testing apparatus can be connected to the test point for monitoring the operation of the apparatus without causing RF interference to the apparatus.

According to an embodiment, a second surface of the covering plate facing the PCB is casted in a form that provides isolation walls and/or a shielding box around at least one component or a component group on the PCB.

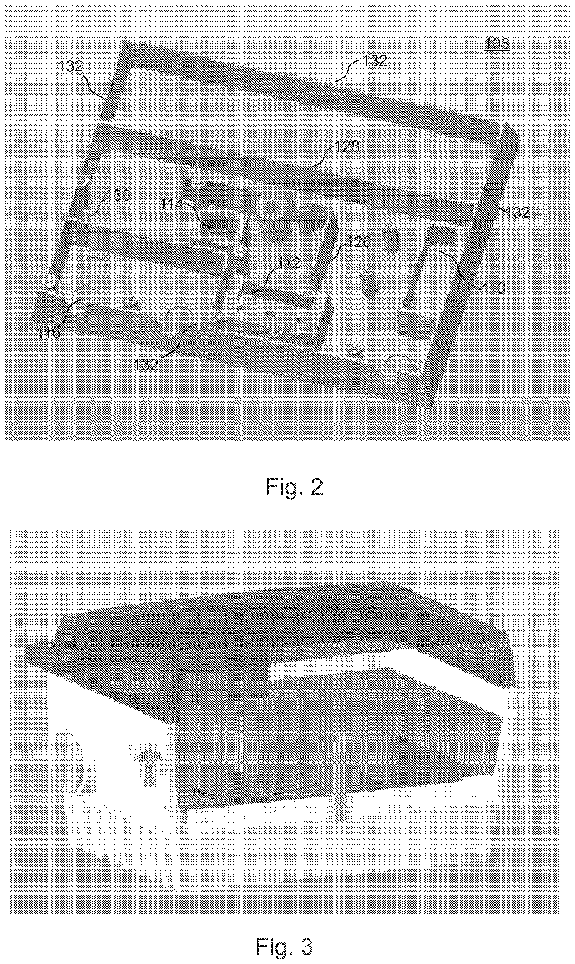

Figure 2 illustrates an example of the structure of the covering plate 108 on the surface facing the PCB. The structure of the apertures 110, 112, 114 arranged as guides for plug-in modules, as shown in Figure 1, is shown more clearly in Figure 2. The walls of the apertures extend upfront from the surface, thus providing a firm and solid guide to install and remove plug-in modules. The aperture 116 for the test point does not require a guide because the test point 118 is fixed to the PCB. Figure 2 further shows casted walls 126, 128 and a shielding box 130, which upon installing the covering plate on the PCB, provide RF isolation for one components or component groups that they surround.

The design of the covering plate is such that the outer edges 132 and/or the walls 126, 128 and the shielding box 130 press the PCB firmly to its place, and provide electrical contact between the PCB and the housing of the apparatus such that the PCB is securely connected to the ground potential of the housing. According to an embodiment, for improving the electrical contact between the covering plate and the PCB, the outer surfaces of the edges 132 may be covered with an electrically conducting material, such as electrically conducting foam or a plait gasket.

According to an embodiment, the electrically conducting material is aluminium, zinc or an electrically conducting plastic. When selecting an appropriate material for the covering plate, in addition to the electrical conducting properties, also the castability and manufacturing costs play an important role. Therefore, regarding metals aluminium (Al) or zinc (Zn) are preferable materials. Alternatively, an electrically conducting plastic could be used instead.

According to an embodiment, the covering plate is attached to the housing by one screw. Depending on the location and the orientation of the apparatus as installed in the network, it may be preferable to ensure secure fastening of the covering plate 108 to the PCB 104 and/or the housing 102. This is preferable at least when the apparatus is installed in vertical or upside down orientation or in a location where the apparatus may be subjected to vibration.

Referring back to Figure 1, the fastening may be carried out using a screw 124 extending preferably through the PCB 104 to the bottom of the housing 102. A skilled person appreciates that while the aim is to keep the number of fastening screws as few as possible, preferably zero, in certain cases, depending e.g. on the size of the apparatus and the covering plate, it may be preferable to use several, such as 2, 3 or 4, fastening screws. On the other hand, alternative means for fastening the covering plate may be used, such as one or more springs exerting spring force between the housing and the covering plate, a separate fastening part between the housing and the covering plate, pressing the covering plate to its position, etc.

Figure 3 illustrates an example of the structure of an apparatus, when the parts have been installed together. Compared to prior art solutions, the covering plate according to the embodiments provides a distinct, straightforward and easy-to-assemble solution for attaching the PCB to the housing of the apparatus, wherein the number of fastening screws is minimized, and the design of the covering plate is casted such that it replaces the required number of shielding boxes and partition walls as well as guides for plug-in modules. The number of separate parts, such as screws, shielding covers, mounting towers, shielding boxes and partition walls, in the apparatus reduces dramatically and assembly becomes easier. As a result, the assembly time of the apparatus in the manufacturing can be reduced to 1/10 or even further compared to prior art apparatuses.

In the above embodiments, the test point 118 is implemented as a component assembled on the PCB and extending upwards from the PCB such that the test point connector extends through the aperture 116 in the covering plate. The test point component needs to be typically assembled manually as a THT (Through-Hole-Technology) assembly on the PCB.

According to an alternative embodiment, a test point connector is arranged in a first surface of the covering plate facing the detachable cover, and a conductor connected to the test point connector and protruding from the second opposite surface of the covering plate, wherein the conductor, upon said installation of the covering plate, is arranged to be pressed against an output of a test signal on the PCB.

Accordingly, the test point connector is implemented in the covering plate, and there is a rigid, elongated conductor on the opposite side of the covering plate. On the PCB, the output of the test signal may be implemented, for example, as a conducting spring. The length of the conductor is arranged such that when the covering plate is installed on the PCB, the conductor extends to the output of the test signal, and for example, presses against the conducting spring such that the test signal may be conducted to the test point connector. Consequently, the number of manually THT-assembled components on the PCB can be further reduced, which shortens the assembly time of the apparatus.

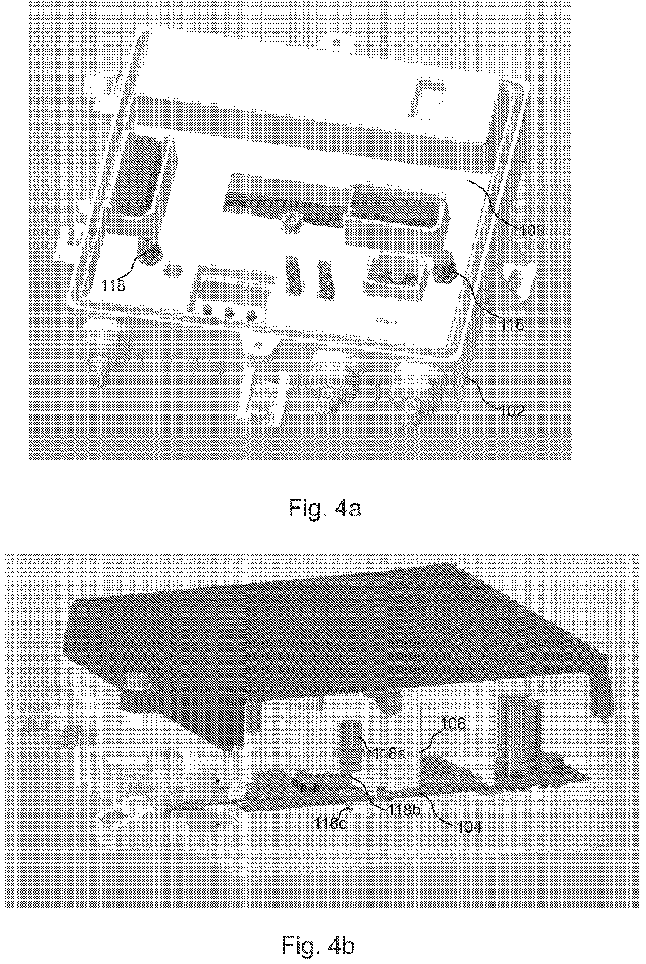

The embodiment is illustrated more in detail in Figures 4a and 4b. Figure 4a shows the covering plate 108 as installed to its place within the housing 102. There are two test points 118, or actually test point connectors, arranged on the surface of the covering plate 108.

The sectional view shown in Figure 4b illustrates the structure of the test point more in detail. The test point comprises the test point connector 118a, the conductor 118b and the output of the test signal 118c, in this case a conducting spring, on the PCB 104. The test point connector 118a extends from the first (upper) surface of the covering plate 108. A rigid, elongated conductor 118b is arranged on the opposite side of the covering plate. When the covering plate 108 is installed within the housing 102 and on the PCB 104, the conductor 118b extends to the output of the test signal 118c. The head of the conductor 118b presses against the conducting spring such that there is an electrical contact between the test point connector 118a and the output of the test signal 118c.

A skilled man appreciates that any of the embodiments described above may be implemented as a combination with one or more of the other embodiments, unless there is explicitly or implicitly stated that certain embodiments are only alternatives to each other.

It is obvious that the present invention is not limited solely to the above-presented embodiments, but it can be modified within the scope of the appended claims.

## Claims

1. An apparatus for use in cable television (CATV) network, the apparatus comprising:
a housing (102);
a printed circuit board (PCB; 104) comprising components necessary for operating the apparatus, wherein the PCB (104) is arranged within the housing (102);
a detachable cover (106) for the housing;
a casted covering plate (108) made of electrically conducting material, wherein the covering plate (108) is arranged, upon installation between the PCB (104) and the detachable cover (106), to cover at least the PCB and attach the PCB to the housing; wherein
the covering plate (108) comprises at least one aperture (110, 112, 114, 116) for a test point (118) of the apparatus or arranged as a guide for a plug-in module (120, 122); and
a test point connector (118a) is arranged in a first surface of the covering plate (108) facing the detachable cover (106), and a conductor (118b) connected to the test point connector (118a) and protruding from the second opposite surface of the covering plate (108), wherein the conductor (118b), upon said installation of the covering plate (108), is arranged to be pressed against an output of a test signal (118c) on the PCB (104).

2. The apparatus according to claim 1, wherein a second surface of the covering plate (108) facing the PCB (104) is casted in a form that provides isolation walls (126, 128) and/or a shielding box (130) around at least one component or a component group on the PCB.

3. The apparatus according to claim 1 or 2, wherein the electrically conducting material is aluminium, zinc or an electrically conducting plastic.

4. The apparatus according to any preceding claim, wherein the covering plate (108) is attached to the housing (102) by one screw (124) .

## Patentansprüche

1. Vorrichtung zur Verwendung in einem Kabelfernsehnetz (CATV), wobei die Vorrichtung Folgendes umfasst:
ein Gehäuse (102);
eine Leiterplatte (PCB; 104), die zum Betreiben der Vorrichtung erforderliche Komponenten umfasst, wobei die PCB (104) innerhalb des Gehäuses (102) angeordnet ist;
eine abnehmbare Abdeckung (106) für das Gehäuse;
eine gegossene Abdeckplatte (108) aus elektrisch leitendem Material, wobei die Abdeckplatte (108) beim Einbau zwischen der PCB (104) und der abnehmbaren Abdeckung (106) angeordnet ist, um mindestens die PCB abzudecken und die PCB an dem Gehäuse zu befestigen;
wobei die Abdeckplatte (108) mindestens eine Öffnung (110, 112, 114, 116) für einen Testpunkt (118) der Vorrichtung aufweist, oder die als Führung für ein Einsteckmodul (120, 122) angeordnet ist; und
wobei ein Testpunktverbinder (118a) in einer ersten Oberfläche der Abdeckplatte (108) angeordnet ist, die der abnehmbaren Abdeckung (106) zugewandt ist, und ein Leiter (118b), der mit dem Testpunktverbinder (118a) verbunden ist und aus dem zweiten gegenüberliegenden Oberfläche der Abdeckplatte (108) herausragt, wobei der Leiter (118b) bei der Installation der Abdeckplatte (108) angeordnet ist, um gegen einen Ausgang eines Testsignals (118c) auf der PCB (104) gedrückt zu werden.

2. Vorrichtung nach Anspruch 1, wobei eine zweite Oberfläche der Abdeckplatte (108), die der Leiterplatte (104) zugewandt ist, in einer Form gegossen ist, die Isolationswände (126, 128) und / oder eine Abschirmbox (130) um mindestens eine Komponente oder eine Komponentengruppe auf der PCB bereitstellt.

3. Vorrichtung nach Anspruch 1 oder 2, wobei das elektrisch leitende Material Aluminium, Zink oder ein elektrisch leitender Kunststoff ist.

4. Vorrichtung nach einem der vorhergehenden Ansprüche, wobei die Abdeckplatte (108) mit einer Schraube (124) an dem Gehäuse (102) befestigt ist.

## Revendications

1. Appareil à utiliser dans un réseau de télévision par câble (CATV), l'appareil comprenant :
un boîtier (102) ;
une carte de circuit imprimé (PCB ; 104) comprenant des composants nécessaires au fonctionnement de l'appareil, dans lequel la PCB (104) est agencée à l'intérieur du boîtier (102) ;
un couvercle amovible (106) pour le boîtier ;
une plaque de recouvrement moulée (108) composée d'un matériau électriquement conducteur, dans lequel la plaque de recouvrement (108) est agencée, lors de l'installation entre la PCB (104) et le couvercle amovible (106), pour couvrir au moins la PCB et fixer la PCB au boîtier ;
dans lequel
la plaque de recouvrement (108) comprend au moins une ouverture (110, 112, 114, 116) pour un point de test (118) de l'appareil ou agencée comme un guide pour un module enfichable (120, 122) ; et
un connecteur de point de test (118a) est agencé dans une première surface de la plaque de recouvrement (108) faisant face au couvercle amovible (106), et un conducteur (118b) connecté au connecteur de point de test (118a) et dépassant de la seconde surface opposée de la plaque de recouvrement (108), dans lequel le conducteur (118b), lors de ladite installation de la plaque de recouvrement (108), est agencé pour être appuyé contre une sortie d'un signal de test (118c) sur la PCB (104).

2. Appareil selon la revendication 1, dans lequel une seconde surface de la plaque de recouvrement (108) faisant face à la PCB (104) est moulée avec une forme qui fournit des parois d'isolation (126, 128) et/ou une boîte de protection (130) autour d'au moins un composant ou d'un groupe de composants sur la PCB.

3. Appareil selon la revendication 1 ou 2, dans lequel le matériau électriquement conducteur est l'aluminium, le zinc ou un plastique électriquement conducteur.

4. Appareil selon une quelconque revendication précédente, dans lequel la plaque de recouvrement (108) est fixée au boîtier (102) par une vis (124).
